(19) Europäisches Patentamt
European Patent Office
Office européen des brevets

(11) Publication number: **0 200 970 B1**

(12) **EUROPEAN PATENT SPECIFICATION**

(45) Date of publication of patent specification: **24.06.92** (51) Int. Cl.$^5$: **H03M 1/68**

(21) Application number: **86105344.5**

(22) Date of filing: **17.04.86**

# (54) Digital-to-analog converter.

(30) Priority: **19.04.85 JP 83819/85**

(43) Date of publication of application:
**12.11.86 Bulletin 86/46**

(45) Publication of the grant of the patent:
**24.06.92 Bulletin 92/26**

(84) Designated Contracting States:
**DE GB NL**

(56) References cited:
**GB-A- 2 022 347**
**GB-A- 2 093 297**
**US-A- 4 278 964**

**IBM TECHNICAL DISCLOSURE BULLETIN, vol. 5, no. 5, October 1962, pages 30-31, New York, US; T.J. HARRISON: "Logarithmic digital to analog converter"**

**NEW ELECTRONICS, vol. 16, no. 2, 25th January 1983, pages 92-93, London, GB; J. MULLEN: "Specifying and using the digital-to-analogue converter"**

**ELEKTRONIK, vol. 31, no. 3, February 1982, pages 78-80, Munich, DE; G. HEINLE: "Gleitkomma-D/A-Umsetzer verringert Ouantisierungsfehler"**

(73) Proprietor: **YAMAHA CORPORATION**
**10-1, Nakazawa-cho**
**Hamamatsu-shi Shizuoka-ken(JP)**

(72) Inventor: **Kohdaka, Takayuki c/o NIPPON GAKKI**
**SEIZO K.K. 10-1, Nakazawa-cho**
**Hamamatsu-shi Shizuoka-ken(JP)**
Inventor: **Ishida, Katsuhiko c/o NIPPON GAKKI**
**SEIZO K.K. 10-1, Nakazawa-cho**
**Hamamatsu-shi Shizuoka-ken(JP)**
Inventor: **Takahashi, Toshiyuki c/o NIPPON GAKKI**
**SEIZO K.K. 10-1, Nakazawa-cho**
**Hamamatsu-shi Shizuoka-ken(JP)**
Inventor: **Ogata, Takashi c/o NIPPON GAKKI**
**SEIZO K.K. 10-1, Nakazawa-cho**
**Hamamatsu-shi Shizuoka-ken(JP)**

(74) Representative: **Kehl, Günther, Dipl.-Phys. et al**
**Patentanwälte Hagemann & Kehl Ismaninger Strasse 108 Postfach 86 03 29**
**W-8000 München 86(DE)**

**EP 0 200 970 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a digital-to-analog converter for converting digital input data into an analog output signal, comprising detector means responsive to the digital input data for detecting the magnitude thereof, said detector means outputting a detection signal representative of the magnitude of said digital input data, digital-to-analog converting means of a predetermined number of bits responsive to said detection signal for converting a mantissa-part of said digital input data into an intermediate analog signal and exponent converting means responsive to said detection signal, said exponent converting means outputting said converted analog signal as the analog output signal.

EP-A2-O 177 902, which was published after the priority date, and, thus, falling under Art. 54(3)EPC, describes a digital-to-analog converter (DAC) which can deal with an input data in the form of an ordinary fixed-point binary number.

As shown in Fig. 1, the DAC comprises a digital shifter 1 for shifting bits $I_0$ to $I_{15}$ of an input data $D_{IN}$ to extract therefrom N consecutive bits to be supplied to a mantissa-part DAC 2. A shift number detector 3 decodes a predetermined number of higher-order bits of the input data $D_{IN}$ to produce a signal representative of the number of bits to be shifted by the digital shifter 1 and supplies the produced signal to the digital shifter 1 and an exponent-part DAC 4. In the case where the input data $D_{IN}$ is represented in two's complement, the digital shifter 1 extracts the N consecutive bits in accordance with the signal fed from the shift number detector 3 in such a manner that the greater the absolute value of the input data $D_{IN}$ is, the higher the order of the N consecutive bits extracted from the input data $D_{IN}$ is. Also, the exponent-part DAC 4 produces an exponent part of the output signal $V_{OUT}$ in accordance with the signal fed from the shift number detector 3.

With the DAC shown in Fig. 1, if the mantissa-part DAC 2 has a higher resolution (for example, a resolution of about 12 bits), the minimum step of variation of the output signal $V_{OUT}$ becomes smaller, so that a total harmonic distortion of the output signal $V_{OUT}$ of higher signal levels desirably becomes smaller. However, even though the mantissa-part DAC 2 is manufactured so as to have a 12-bit resolution, the actual accuracy thereof is 10 bits at the best. In such a case, although the low accuracy does not much affect on the higher level signals, the total harmonic distortion of the output signal of lower signal levels becomes worse.

On the other hand, it is not difficult to manufacture a mantissa-part DAC having an accuracy of about 10 bits, so that it is possible to improve the total harmonic distortion of the output signal of lower signal levels by arranging the mantissa-part DAC to have a resolution of 10 bits. In this case, however, the total harmonic distortion of the output signal of higher signal levels will be deteriorated since the minimum step of variation of the higher level output signal becomes large.

Thus, with the aforesaid floating-point-type DAC, the total harmonic distortion of the output signal is deteriorated in one of the higher and lower signal level ranges depending on the selection of the accuracy of a mantissa-part DAC thereof.

A general-use floating point DAC is described in ELEKTRONIK, vol. 31, no. 3, February 12, 1982, pages 78 -80; G. Heinle: "Gleitkomma-D/A-Umsetzer verringert Quantisierungsfehler". This known DAC comprises detector means responsive to the digital input data for detecting the magnitude thereof, digital-to-analog converting means of a predetermined number of bits for converting a mantissa-part of said digital input data into a first analog value, means providing a second analog value corresponding to an exponent part of the digital input data and means combining the first and second analog values to form the desired analog output signal. Such a floating point DAC has a high conversion accuracy and can convert an input data of a small magnitude into an analog form with little distortion, however, it must be supplied with an input data in the form of a floating point number. Furthermore there are no means provided in order to reduce the harmonic distortion of the output signal of lower signal levels.

GB-A-2 093 297 discloses a DAC comprising a decoder responsive to at least 2 bits of an input digital signal, said decoder producing an output signal indicating that the magnitude of an analog signal represented by the input digital signal is greater than a predetermined value or not. The DAC comprises further a first data selector controlled by the output signal form said decoder for selecting one of two sets of consecutive bits of said input digital signal, a first D/A converter having an external reference voltage input terminal and being responsive to the output data from said first data selector for producing an output analog signal by using a first reference voltage applied to said external reference voltage input terminal, a digital data generator for producing a predetermined digital data, a second data selector controlled by said output signal from said decoder for selecting one of a said of executive bits of said input digital signal and said predetermined digital data from said digital data generator. The DAC further comprises a second D/A converter having an external reference voltage input terminal and being responsive to the output data from said second data selector for producing an output analog signal by using a second reference voltage applied to said external reference voltage input terminal, said second D/A converter producing a voltage having a specific relationship with respect to said second reference voltage when said predetermined digital data is applied thereto via said second data selector, a D.C.-voltage source for producing a predetermined voltage which is fed to said external reference voltage input terminal of said second D/A converter as said second reference voltage, and means for producing said first reference voltage fed to said external reference voltage input terminal of said first D/A converter, said means being controlled by said output signal from said decoder for supplying said external reference voltage input terminal of said first D/A converter with the sum of said second reference voltage and the output voltage of said second D/A converter, or only said second reference voltage. More specifically there are provided two DACs and when the number of bits of the input is larger than the number of bits of the first DAC so that some bits thereof overflow, the overflow bits are processed by the second DAC. Then the output of the second DAC is inputted to the first DAC so that the first DAC is subject to the offset corresponding to the output of the second DAC thus reducing the quantization error. In other words, the step size on expansion is made substantially small enough so that the problem is resolved that quantization error occurs greatly on expansion due to the wider step sizes. There is, however, no provision to improve the total harmonic distortion of the output signal of lower signal levels.

IBM TECHNICAL DISCLOSURE BULLETIN, vol. 5, no. 5, October 1962, pages 30 - 31, T.J. Harrison: "Logarithmic digital to analog converter" discloses a logarithmic digital-to-analog converter which is designed to convert the binary digital input into the logarithmic analog output. The known converter includes a counter which determines the number of the most significant bit of an 11-n input signal. This number is equal to the characteristic of the logarithm and can assume n possible levels. In order to determine the mantissa, a sufficient number of lower order bits are decoded and fed to a $2^{i}$-level A/D converter. In the given example i has the value of 2 so that the $2^{i}$-level A/D converter is in fact a 4-level A/D converter. However, the document is silent about the design of this converter for larger values of i, as for instance i = 16, in which case 65 536 levels must be converted. The document is especially silent about the problem of how to reduce the total harmonic distortion of output signals of lower signal levels.

US-A-4 278 964 teaches a seismic playback system and especially an apparatus for converting wide dynamic amplitude range digital data recorded in floating point digital wordform, comprising a binary coded mantissa and a binary coded exponent, to an analog signal, or oscillogram, of selectively compressed and/or amplified dynamic amplitude range. The digital word, occupying a number of binary bit positions, is, in algebraic form $\pm AG^{E}$, where A represents the mantissa, or argument, G represents the base, or radix, of the number system used and E represents the exponent. Since base G is constant, for example at 8, the only binary bits that need to be recorded are those representing the mantissa A and the exponent E. In reconverting the digital data to analog form for making an oscillogram, it is desired to selectively amplify and/or compress the dynamic range and, yet, at the same time avoid introducing serious distortions. The function generator for reconverting the digital data to analog form is provided with a mantissa digital-to-analog converting means for converting a mantissa-part of said digital data into a first analog signal and circuit means responsive to said first analog signal to produce second analog signals, whose voltages are $G^{E}$ magnifications of said first analog signal, where G represents the base of the number system used and E represents the exponent. According to this prior art, the exponent part and the mantissa part are connected together via a buffer amplifier. In addition, by use of the positive and negative voltages to be changed over, this prior art system obtains the analog output. The known system is intended for displaying a stored wave-shape by an oscillograph. Therefore the data is compressed by use of the logarithmic representation whereby dealing with the input signal having a wide dynamic range. Also this document is silent about the problem of how the total harmonic distortion of the output signal of lower signal levels can be improved.

It is therefore an object of the present invention to provide a DAC in which the total harmonic distortion of an output signal can be minimized over an entire range of its signal level.

The digital-to-analog converter according to the invention is characterized by control means, incorporated in said digital-to-analog converting means, responsive to said detection signal for changing the number of operative bits of said digital-to-analog converting means, said control means decreasing the number of operative bits of said digital-to-analog converting means with a decrease of the magnitude of said digital input data.

Examples of the present invention will now be described with reference to accompanying drawings, in which:-

Fig. 1 is a block diagram of a DAC (digital-to-analog converter) before improvement;

Fig. 2 is a block diagram of a DAC 10 provided in accordance with a first embodiment of the present invention;

Fig. 3 is a circuit diagram of the exponent value detector 13 of the DAC 10 shown in Fig. 2;

Fig. 4 is an illustration showing the relation between the bits of the input data $D_{IN}$ and the bits supplied to the mantissa-part DAC 22 of the DAC 10 of Fig. 2;

Fig. 5 is a circuit diagram of the digital shifter 21 of the DAC 10 of Fig. 2;

Fig. 6 is a circuit diagram of the exponent-part DAC 50 of the DAC 10 of Fig. 2;

Fig. 7 is a chart showing total harmonic distortions of the DAC 10 and various other DACs; and

Fig. 8 is a block diagram of a DAC 22a provided in accordance with a second embodiment of the invention.

Fig. 2 shows a block diagram of a DAC provided in accordance with a first embodiment of the present invention. In Fig. 2, sixteen-bit digital data $D_{IN}$ represented in two's complement is applied to input terminals $T_0$ to $T_{15}$, wherein the sign bit thereof is applied to the input terminal $T_{15}$ and the LSB (least significant bit) thereof is applied to the input terminal $T_0$. Each of the bits $I_0$ to $I_{15}$ is passed through serially connected two inverters 11 and 12, whereby sixteen bit-data $J_0$ to $J_{15}$ equivalent respectively to the bits $I_0$ to $I_{15}$ are produced. The higher-order seven bits $J_9$ to $J_{15}$ are supplied to an exponent value detector 13 which decodes the bits $J_9$ to $J_{15}$ to produce one of seven signals $S_0$ to $S_6$ representing an exponent value of an analog output signal $V_{OUT}$ of this DAC 10.

As shown in Fig. 3, the exponent value detector 13 comprises six exclusive-OR gates 109 to 114 to which the bits $J_9$ to $J_{14}$ are respectively supplied at one input terminals thereof. The other input terminals of the exclusive-OR gates 109 to 114 are supplied with the bit $J_{15}$. This exponent value detector 13 further comprises seven AND gates $AN_0$ to $AN_6$. Input terminals of each of the AND gates $AN_0$ to $AN_6$ are indicated by circles on an input signal line of the corresponding one of the AND gates. Output terminals of the exclusive-OR gates 114 to 109 are connected to the first input terminals of the AND gates $AN_0$ to $AN_5$, respectively. The output terminals of the exclusive-OR gates 109 to 114 are also connected to input terminals of inverters 116 to 121, respectively. An output terminal of the inverter 116 is connected to the first input terminal of the AND gate $AN_6$, and an output terminal of the inverter 117 is connected to the second input terminals of the AND gates $AN_5$ and $AN_6$. An output terminal of the inverter 118 is connected to the second input terminal of the AND gate $AN_4$ and the third input terminals of the AND gates $AN_5$ and $AN_6$. In a similar manner, an output terminal of the inverter 119 is connected to the input terminals of the AND gates $AN_3$ to $AN_6$, an output terminal of the inverter 120 to the input terminals of AND gates $AN_2$ to $AN_6$, and an output terminal of the inverter 121 to the input terminals of the AND gates $AN_1$ to $AN_6$. When opened, the AND gates $AN_0$ to $AN_6$ output the signal $S_0$ to $S_6$, respectively. With this exponent value detector 13, when the bit $J_{15}$ is "0", that is to say, when the input data $D_{IN}$ is a positive value, "N" of the outputted signal $S_N$ (N is any one of "1" to "6") is determined by the number of "0" bits counted from the bit $J_{14}$ toward the bit $J_9$ until a "1" bit is first detected. In other words, the "N" is determined by the number of leading "0" bits of the input data $D_{IN}$. For example, when the bit $J_{15}$ is "0" and if only the bits $J_{13}$ and $J_{11}$ are "1", the number of leading "0" bits of the input data $D_{IN}$ is "1", so that the signal $S_1$ is outputted. On the other hand, when the bit $J_{15}$ is "1", that is to say, when the input data $D_{IN}$ is negative, the "N" of the signal $S_N$ is determined by the number of "1" bits counted from the bit $J_{14}$ toward the bit $J_9$ until a "0" bit is first detected. In other words, the "N" is determined by the number of leading "1" bits of the input data $D_{IN}$. For example, in the case where only the bits $J_{10}$ and $J_9$ are "0", the number of leading "1" bits of the input data $D_{IN}$ is "4", so that the signal $S_4$ is outputted. Thus, the exponent value detector 13 determines the "N" of the signal $S_N$ based on the number of those bits of the input data $D_{IN}$ which are counted from the bit $I_{14}$ toward the bit $I_9$ until a bit different in state from the bit $I_{15}$ is first detected. In the case where a bit which is different in state from the sign bit is not detected from the bits $J_{14}$ to $J_9$, the exponent value detector 13 outputs the signal $S_6$ irrespective of the state of the bit $J_{15}$. Thus, the exponent value detector 13 selectively outputs the signal $S_N$ in accordance with the absolute value of the input data $D_{IN}$ represented by the bits $I_{14}$ to $I_0$, wherein the "N" becomes greater when the absolute value of the input data becomes smaller. And, when the absolute value of the input data $D_{IN}$ is less than "512" in decimal, the signal $S_6$ is always outputted. In the case where the input data $D_{IN}$ takes the form of an ordinary binary value, an inversion of the bit $I_{15}$ is applied to the exponent value detector 13 in stead of the bit $J_{15}$.

Referring again to Fig. Fig. 2, the bits $J_{14}$ to $J_0$ are also supplied to a digital shifter 21 which shifts the supplied bits $J_{14}$ to $J_0$ by bits whose number is determined in accordance with the signals $S_0$ to $S_6$. The digital shifter 21 then outputs, from output terminals $TD_0$ to $TD_{10}$ thereof, eleven consecutive bits among the bits $J_{14}$ to $J_0$ obtained as the result of its shift operation. When supplied with the signal $S_0$, the digital shifter 21 outputs the bits $J_4$ to $J_{14}$ from the output terminals $TD_0$ to $TD_{10}$, respectively, and when supplied with the signal $S_1$, it outputs the bits $J_3$ to $J_{13}$ from the output terminals $TD_0$ to $TD_{10}$, respectively. In a similar manner, when supplied with the signal $S_2$, the digital shifter 21 outputs the bits $J_2$ to $J_{12}$ from the

output terminals $TD_0$ to $TD_{10}$, respectively, and when supplied with the signal $S_3$, it outputs the bits $J_1$ to $J_{11}$ from the output terminals $TD_0$ to $TD_{10}$, respectively. And, when supplied with the signal $S_4$, the digital shifter 21 outputs the bits $J_0$ to $J_{10}$ from the output terminals $TD_0$ to $TD_{10}$, respectively (see arrows in Fig. 4). Also, when supplied with the signal $S_5$ outputted from the exponent value detector 13, the digital shifter 21 outputs the bits $J_0$ to $J_9$ from the output terminals $TD_1$ to $TD_{10}$, respectively. In this case, the digital shifter 21 outputs an indefinite signal (a "1" or a "0" signal) from the output terminal $TD_0$. On the other hand, when supplied with the signal $S_6$, the digital shifter 21 outputs the bits $J_0$ to $J_8$ from the output terminals $TD_2$ to $TD_{10}$, respectively. In this case, the digital shifter 21 outputs indefinite signals from the output terminals $TD_0$ and $TD_1$.

The digital shifter 21 is constructed, for example, as shown in Fig. 5. The digital shifter 21 comprises seven columns of switches $SW_{0-0}$ to $SW_{0-10}$, $SW_{1-0}$ to $SW_{1-10}$, ...$SW_{6-0}$ to $SW_{6-10}$. These switches may be constituted by FETs, transistors or the like. In this case, all of the switches in the same column are closed when the corresponding one of the signals $S_0$ to $S_6$ is applied thereto. For example, the switches $SW_{0-0}$ to $SW_{0-10}$ in the first column are closed when the signal $S_0$ is supplied thereto. In this case, the bits $J_{14}$ to $J_4$ are supplied respectively to the output terminals $TD_{10}$to $TD_0$ of this digital shifter 21. In a similar manner, when the signal $S_1$ is supplied to the digital shifter 21, the switches $SW_{1-0}$ to $SW_{1-10}$ close, so that the bits $J_{13}$ to $J_3$ are supplied respectively to the output terminals $TD_{10}$ to $TD_0$ of this digital shifter 21. And, when the signal $S_6$ is supplied to the digital shifter 21, the switches $SW_{6-0}$ to $SW_{6-10}$ close, so that the bits $J_8$ to $J_0$ are supplied respectively to the output terminals $TD_8$ to $TD_2$.

Referring again to Fig. 2, shown at 22 is a mantissa-part DAC of this DAC 10 which comprises 12-stage 2R-R resistor ladder network 23. An R resistor of each of the first to twelfth stages of the ladder network 23 is composed of a resister having a resistance value of $R_1$, and a 2R resistor of each of the first to tenth stages of the ladder network 23 is composed of serially connected two resistors each having a resistance value of $R_1$. A 2R resistor of the eleventh stage of the ladder network 23 is composed of a resistor 24 of $R_1$ and two groups of resistors 25 and 26 each group composed of serially connected two resistors each having a resistance value of $R_1$, a junction point $P_1$ of the two groups of resistors 24 and 25 being connected to the resistor 24. Similarly, a 2R resistor of the twelfth stage of the ladder network 23 is composed of a resistor 27 of $R_1$ and two groups of resistors 28 and 29 each group composed of serially connected two resistors each having a resistance value of $R_1$, a junction point $P_2$ of the two groups of resistors 28 and 29 being connected to the resistor 27. The free end of the R resistor of the twelfth or the last stage of the ladder network 23 is connected to a source of voltage $V_{DD}$ through serially connected two resistors each having a resistance value of $R_1$, and also connected to the ground through serially connected two resistors each having a resistance value $R_1$. The 2R resistor of the first stage of the ladder network 23 is connected with serially connected two inverters $30_{-1}$ and $31_{-1}$, and the 2R resistor of the second stage of the ladder network 23 is connected with serially connected two inverters $30_{-2}$ and $31_{-2}$. This is true with respect to the 2R resistors of the third to tenth stages of the ladder network 23. Similarly, the resistor group 25 is connected with serially connected two inverters $30_{-11}$ and $31_{-11}$, and the resistor group 26 is connected with serially connected two inverters $30_{-12}$ and $31_{-12}$.

This is true with the resistor groups 28 and 29. An inversion of the bit $I_{15}$ by the inverter 11 is supplied to an input terminal of the inverter $30_{-1}$, and the bits outputted from the output terminals $TD_{10}$ to $TD_2$ of the digital shifter 21 are supplied to input terminals of the inverters $30_{-1}$ to $30_{-10}$, respectively. The two bits outputted from the output terminals $TD_1$ and $TD_0$ are supplied to a mantissa-part-bit control circuit 40. Each of the inverters $31_{-1}$ to $31_{-14}$ outputs a ground level signal as "0" and a voltage equal to $V_{DD}$ as "1".

The mantissa-part-bit control circuit 40 is provided for changing the number of operable bit-stages of the mantissa-part DAC 22. The mantissa-part-bit control circuit 40 comprises two exclusive OR gates EXOR1 and EXOR2, two NOR gates NOR1 and NOR2 and an inverter INV1. A signal $M_1$ outputted from the terminal $TD_1$, which corresponds to the eleventh bit-stage of the mantissa-part DAC 22, is supplied to one input terminal of the exclusive OR gate EXOR1. The signal $M_1$ is also supplied to the input terminal of the inverter $30_{-12}$, whereby a signal X is obtained at the output terminal of the inverter $31_{-12}$. The other input terminal of the exclusive OR gate EXOR1 is supplied with an output signal the NOR gate NOR1. An output of the exclusive OR gate EXOR1 is supplied to the input terminal of the inverter $30_{-11}$, whereby a signal W is obtained at the output terminal of the inverter $31_{-11}$. A signal $M_0$ outputted from the terminal $TD_0$, which corresponds to the twelfth bit-stage of the mantissa-part DAC 22, is supplied to one input terminal of the exclusive OR gate EXOR2. The signal $M_0$ is also supplied to the input terminal of the inverter $30_{-14}$, whereby a signal Z is obtained at the output terminal of the inverter $31_{-14}$. The other input terminal of the exclusive OR gate EXOR2 is supplied with an output signal the inverter INV1. An output of the exclusive OR gate EXOR2 is supplied to the input terminal of the inverter $30_{-13}$, whereby a signal Y is obtained at the output terminal of the inverter $31_{-13}$. The signals $S_5$ and $S_6$ are supplied to input terminals of the NOR gate NOR2, and the signal $S_5$ and an output of the NOR gate NOR2 are supplied to input terminals of the NOR gate NOR1. The output signal of the NOR gate NOR2 is also supplied to an input terminal of the inverter INV1. The mantissa-part-bit control circuit 40 thus constructed causes the four signals W, X, Y and Z supplied respectively to the resistor groups 25, 26, 28 and 29 to be changed in accordance with the states of the signals $S_5$ and $S_6$, as shown in Table 1.

Table 1

| $S_5$ | $S_6$ | W | X | Y | Z |
|---|---|---|---|---|---|
| 0 | 0 | $M_1$ | $M_1$ | $M_0$ | $M_0$ |
| 1 | 0 | $M_1$ | $M_1$ | $\overline{M_0}$ | $M_0$ |
| 0 | 1 | $\overline{M_1}$ | $M_1$ | $\overline{M_0}$ | $M_0$ |

An output signal $S_A$ of the mantissa-part DAC 22 which appears at the junction point of the 2R and R resistors of the first stage of the ladder network 23 is supplied to an exponent-part DAC 50 of seven-stage type. As shown in Fig. 6, the exponent part DAC 50 comprises seven analog switches $ASW_0$ to $ASW_6$ and a six-stage R-2R resistor ladder network 130. Each stage of the ladder network 130 comprises an R resistor of a resistance value of $R_2$ and a 2R resistor composed of serially connected two resistors each having a resistance value of $R_2$. The free end of the R resistor of the first stage of the ladder network 130 is supplied with the output signal $S_A$ of the mantissa-part DAC 22, while the free ends of the 2R resistors of all of the stages of the ladder network 130 are connected to a source of voltage $V_{DD}/2$. The free end of the R resistor of the first stage of the ladder network 130 and the junction points between the R and 2R resistors of the first to sixth stages of the ladder network 130 are connected respectively through analog switches $ASW_0$ to $ASW_6$ to an output terminal 131 of this DAC 10. And, the signals $S_0$ to $S_6$ outputted from the exponent value detector 13 are supplied respectively to control terminals of the analog switches $ASW_0$ to $ASW_6$ so that one of the switches is brought into an ON state by the corresponding one of the signals $S_0$ to $S_6$ which is in the "1" state.

The operation of this DAC 10 will now be described.

As will be appreciated from Fig. 4, one of the signals $S_0$ to $S_6$ is outputted in accordance with the magnitude of the input data $D_{IN}$. For example, when the input data $D_{IN}$ is in the range of between "32767" and "16384" in decimal, the signal $S_0$ is outputted, and when the input data $D_{IN}$ is in the range of between "16383" and "8192" in decimal, the signal $S_1$ is outputted. When the input data $D_{IN}$ is relatively large in magnitude, that is, when a signal level of the output signal $V_{OUT}$ is greater than -30dB, one of the five signals $S_0$ to $S_4$ is outputted. In this case, the signals $S_5$ and $S_6$ are both "0", so that the NOR gate NOR2 outputs a "1" signal. And therefore, the inverter INV1 and the NOR gate NOR1 both output "0", so that the exclusive OR gates EXOR1 and EXOR2 serves as mere buffers. Consequently, both of the signals W and X become equal in state to the signal $M_1$, and also both of the signals Y and Z become equal in state to the signal $M_0$. When the signals W and X are equal in state to each other, the two resistor groups 25 and 26 serve as a single resistor having a resistance value of $R_1$. And therefore, if the signals W and X are equal in state to the signal $M_1$, the application of the signals W and X to the junction point $P_1$ respectively through the resistor groups 25 and 26 is equivalent to an application of the signal $M_1$ to the junction point $P_1$ through a resistor of $R_1$. Similarly, if the signals Y and Z are equal in state to the signal $M_0$, the application of the signals Y and Z to the junction point $P_0$ respectively through the resistor groups 28 and 29 is equivalent to an application of the signal $M_0$ to the junction point $P_0$ through a resistor of $R_1$. Thus, when one of the signals $S_0$ to $S_4$ is outputted, the mantissa-part DAC 22 operates as a twelve-bit DAC. In this case, the digital shifter 21 outputs from the output terminals $TD_{10}$ to $TD_0$ thereof those consecutive eleven bits among the bits $J_{14}$ to $J_0$ which are selected in accordance with the one of the signals $S_0$ to $S_4$ (see the arrows shown in Fig. 4). Thus, in the case where the magnitude of the input data $D_{IN}$ is greater than a predetermined value, the mantissa-part DAC 22 operates as a twelve-bit DAC, so that the minimum step of variation of the output signal $V_{OUT}$ is rendered small, whereby the harmonic distortion thereof is minimized.

When the magnitude of the input data $D_{IN}$ is relatively small, that is, when the output signal $V_{OUT}$ is not greater than -30 dB but greater than -36dB, the signal $S_5$ is outputted. In this case, the relation between the signal $M_1$ and the signals W and X is the same as that in the above case, however the relation between the signal $M_0$ and the signals Y and Z is changed to that shown in Table 1. More specifically, the signals Y and Z are in inversed relation in state to each other irrespective of the state of the signal $M_0$. In this case, if one of the two signals Y and Z is at the ground level, the other of the signals is at a source voltage level ($V_{DD}$),

so that the potential at the junction point $P_0$ becomes equal to $V_{DD}/2$. As a result, the function of the mantissa-part DAC 22 in this case becomes equivalent to that of the mantissa part DAC 22 from which the least significant bit stage is removed. In other words, the mantissa-part DAC 22 operates as a DAC of eleven-bit type. When the signal $S_5$ is outputted, the digital shifter 21 outputs the bits $J_0$ to $J_9$ from the output terminals $TD_1$ to $TD_{10}$, respectively, so that the lower-order ten bits of the input data $D_{IN}$ are supplied to the mantissa-part DAC 22.

When the magnitude of the input data $D_{IN}$ is smaller than that in the above case, the signal $S_6$ is outputted from the exponent value detector 13. Consequently, the signals W and X are in inversed relation to each other, and the signals Y and Z are also in inversed relation to each other. And therefore, the potentials at the junction points $P_1$ and $P_0$ both become equal to half of the source voltage $V_{DD}$, i. e., $V_{DD}/2$, so that the least significant two bits are removed from the mantissa-part DAC 22. Thus, when the signal $S_6$ is outputted, the mantissa-part DAC 22 operates as a DAC of a ten-bit type. In this case, the digital shifter 21 outputs the bits $J_0$ to $J_8$ from the output terminals $TD_2$ to $TD_{10}$, so that the lower-order nine bits of the input data $D_{IN}$ are supplied to the mantissa-part DAC 22.

Thus, when the magnitude of the input data $D_{IN}$ is small, the mantissa-part DAC 22 operates as a DAC of an eleven-bit type or a ten-bit type, so that the total harmonic distortion of the output signal $V_{OUT}$ is prevented from increasing.

Description will now be given as to the total harmonic distortion characteristic of the above described DAC 10.

Fig. 7 illustrates total harmonic distortions of various DACs in terms of signal levels of output signals thereof. In Fig. 7, areas lying between two adjacent lines inclined downwardly in the right-hand direction respectively define total harmonic distortions of DACs of ten-bit to sixteen-bit types which have no exponent-part DAC. The area between two adjacent broken lines defines the total harmonic distortion of an ordinary floating-point-type DAC which has a ten-bit type mantissa-part DAC having an accuracy of ten bits and a seven-stage exponent-part DAC. As the exponent-part DAC of this ordinary floating-point-type DAC is of a seven-stage type, the total harmonic distortion becomes flat in the region of above -36dB. The area hatched by lines inclined downwardly in the right-hand direction defines the total harmonic distortion of another ordinary floating-point-type DAC which has a twelve-bit type mantissa-part DAC having an accuracy of ten bits and a five-stage exponent-part DAC. Since the mantissa-part DAC of this ordinary floating-point-type DAC is inferior in accuracy to the mantissa-part DAC of the first-mentioned ordinary floating-point-type DAC by two bits, the total harmonic distortion is deteriorated in the region of smaller signal levels. On the other hand, the area hatched by lines inclined downwardly in the left-hand direction defines the total harmonic distortion of a still another ordinary floating-point-type DAC which has a twelve-bit type mantissa-part DAC having an accuracy of twelve bits and a five-stage exponent-part DAC (i. e., an ideal DAC of a floating-point type). As the exponent-part DAC of this ordinary floating-point-type DAC is of a five-stage type, the error in the mantissa-part DAC is rendered $1/2^4$ times smaller. And therefore, the total harmonic distortion of this ordinary floating-point-type DAC with respect to the signals below - 24dB is the same as that of the sixteen-bit DAC having no exponent-part DAC, and the total harmonic distortion thereof in the region of above -24dB is flat.

With the aforesaid DAC 10 provided in accordance with the first embodiment of the invention, when the signal level is small, the number of bits of the mantissa-part DAC 22 becomes equal to ten, wherein the accuracy thereof is also ten bits. And, the number of stages of the exponent-part DAC 50 is seven in this case, so that the error in the mantissa-part DAC 22 is rendered $1/2^6$ smaller. Thus, when the signal level is below - 36dB, the aforesaid DAC 10 operates as a 16-bit DAC having no mantissa-part. When the signal level is above -24dB, the signal $S_4$ is outputted, so that only the five stages of the exponent-part DAC 50 operates. Consequently, the signal level of the output signal becomes greater, so that the total harmonic distortion of the DAC 10 is flat. When the signal level is between -24dB and -36dB, the number of bits of the mantissa-part DAC 22 becomes equal to eleven bits, wherein the accuracy of the mantissa-part DAC 22 is ten bits. In this case, the number of stages of the exponent-part DAC 50 is six, so that the total harmonic distortion of the DAC 10 is defined by an area in the form of steps. Thus, the total harmonic distortion of the DAC 10 according to this embodiment is defined by an area substantially equal to the area for the ideal floating-point-type DAC hatched by the lined inclined downwardly in the left-hand direction.

A second embodiment of the present invention will now be described with reference to Fig. 8.

A DAC 10a according to this second embodiment differs from the DAC 10 shown in Fig. 2 in the following respects:

An R resistor (R1) of the last bit-stage of an R-2R ladder resistor network 23a of a mantissa-part DAC 22a is connected with a resistor network 60 of an error correction circuit 61. The resistor network 60 comprises resistors 62 to 71 each having a resistance value of $R_1$. The error correction circuit 61 further comprises inverters 72 to 79, NAND gates 80 to 83 and a NOR gate 84. An inversion of the bit $J_{15}$ by an inverter 85 is supplied to one input terminal of an exclusive OR gate 86, the other input terminal of which is connected through a resistor 87 to the source of voltage $V_{DD}$. The other input terminal of the exclusive OR gate 86 is also connected to a terminal 88. If the error correction circuit 61 should work when the MSB of the input data $D_{IN}$ is in the state of "0", a "0" signal is applied to the terminal 88. On the other hand, if the error correction circuit 61 should work when the MSB of the input data $D_{IN}$ is in the "1" state, a "1" signal is applied to the terminal 88. Thus, when an error correction is required, a "1" signal is outputted from an output terminal of the exclusive OR gate 86 to the error correction circuit 61. Three input terminals 87 to 89 are provided for receiving control bits A, B and C, respectively. The control bit A is supplied together with the output signal of the NOR gate NOR2 of the mantissa-part-bit control circuit 40 to input terminals of a NAND gate 90. The control bit B is supplied together with the output signal of the inverter INV1 of the mantissa-part-bit control circuit 40 to input terminals of a NOR gate 91. Similarly, the control bit C is supplied together with the output signal of the NOR gate NOR2 to input terminals of a NAND gate 92. Output signals of the gates 90 to 92 are supplied to the error correction circuit 61 respectively through inverters 93 to 95.

With this construction, when the output signal of the exclusive OR gate 86 is "1" and when both of the signals $S_5$ and $S_6$ outputted from the exponent-value detector 13 are "0", the states of the output signals of the inverters 72 to 75 vary in accordance with the states of the control bits A to C so that the voltage of an output signal $S_B$ of the mantissa-part DAC 22a is shifted as shown in Table 2.

Table 2

| A | B | C | shift amount |
|---|---|---|---|
| 0 | 0 | 0 | $-V_{LSB}/2$ |
| 0 | 0 | 1 | $-V_{LSB}/4$ |
| 0 | 1 | 0 | 0 |
| 0 | 1 | 1 | $+V_{LSB}/4$ |
| 1 | 0 | 0 | $+V_{LSB}/2$ |

It will be appreciated from Table 2 that when the control bits A, B and C are, for example, "0", "0" and "0", respectively, the voltage of the signal $S_B$ is decreased by an amount equal to half of $V_{LSB}$, wherein $V_{LSB}$ is a voltage which is controlled by the last-bit stage of the mantissa-part DAC 22a.

When any one of the signals $S_5$ and $S_6$ is "1", the output of the NOR gate NOR2 is rendered "0", while the output of the inverter INV1 is rendered "1". As a result, the output signals of the NAND gate 90, NOR gate 91 and NAND gate 92 are rendered "1", "0" and "1", respectively, which is equivalent to the case where the control bits A, B and C are equal respectively to "0", "1" and "0". And therefore, no correction is carried out in this case. In other words, the correction of the output signal $S_B$ is performed only when the mantissa-part DAC 22a operates as a twelve-bit DAC.

Although the maximum number of bits of the mantissa-part DACs 22 and 22a and the number of stages of the exponent-part DAC 61 are 12 and 7, respectively, in the aforesaid embodiments, these numbers can be changed to any desired values. Also, the number of bits of the input data $D_{IN}$ should not necessarily be restricted to "16".

As described above, with the DAC according to the present invention, the accuracy of the mantissa-part DAC in terms of the resolution thereof can be enhanced at lower signal levels, while the minimum step of variation of the output signal of the mantissa-part is decreased at higher signal levels. With this DAC therefore, the total harmonic distortion can be decreased over a range from the lower signal levels to the higher signal levels.

## Claims

**1.** A digital-to-analog converter for converting digital input data into an analog output signal comprising:

(a) detector means (13) responsive to the digital input data for detecting the magnitude thereof, said detector means outputting a detection signal representative of the magnitude of said digital input data;

(b) digital-to-analog converting means (22) of a predetermined number of bits responsive to said detection signal for converting a mantissa-part of said digital input data into an intermediate analog signal;
(c) exponent converting means (50) responsive to said detection signal, said exponent converting means outputting said converted analog signal as the analog output signal;

characterized by:
(d) control means (40), incorporated in said digital-to-analog converting means, responsive to said detection signal for changing the number of operative bits of said digital-to-analog converting means (22), said control means (40) decreasing the number of operative bits of said digital-to-analog converting means (22) with a decrease of the magnitude to said digital input data.

**2.** A digital-to-analog converter according to claim 1, wherein the digital input data is in the form of two's complement of the magnitude thereof, said detector means detecting the number of leading "0" bits of the digital input data when the digital input data is positive and detecting the number of leading "1" bits of the digital input data when the digital input data is negative, said detector means outputting said detected number as said detection signal.

**3.** A digital-to-analog converter according to claim 2, wherein said digital-to-analog converting means comprises:
digital shifting means responsive to said detection signal from said detector means for shifting the digital input data in the direction of the most significant bit thereof by bits equal in number to said detected number to form said mantissa part; and
a digital-to-analog converting circuit of the predetermined number of bits for converting said mantissa part into an analog form to produce said intermediate analog signal.

**4.** A digital-to-analog converter according to claim 3, wherein said digital-to-analog converting circuit comprises an R-2R resistor ladder network of the predetermined number of stages, the 2R resistors of said ladder network being supplied with said mantissa part of the digital input data, one terminal end of said ladder network on the side of the least significant bit stage thereof being supplied with a bias voltage to determine the center of range of said intermediate analog signal, said intermediate analog signal being outputted from the other terminal end of said ladder network.

**5.** A digital-to-analog converter according to claim 4, wherein said control means comprises a control circuit which causes the 2R resistors of the least significant bit stages of said ladder network to be supplied with said bias voltage to thereby preventing said least significant bit stages from functioning, the number of said least significant bit stages being determined in accordance with said detection signal.

**6.** A digital-to-analog converter according to claim 1, wherein said exponent converting means comprises:
circuit means responsive to said intermediate analog signal to produce a predetermined number of analog signals whose voltages are $2^{-n}$ (n = 0, 1, 2, ...) magnifications of said intermediate analog signal; and
switch circuit means connected to said circuit means for selectively outputting one of said predetermined number of analog signals as the analog output signal in accordance with said detection signal.

**7.** A digital-to-analog converter according to claim 6, wherein said circuit means comprises an R-2R resistor ladder network connected at one end thereof to said digital-to-analog converting means.

**8.** A digital-to-analog converter according to claim 4 further comprises terminal means for receiving a predetermined number of control bits and a correction circuit means connected with said one terminal end of said R-2R resistor ladder network, said correction circuit means causing said bias voltage at said one terminal end of said R-2R resistor ladder network to vary in accordance with said control bits.

**9.** A digital-to-analog converter according to claim 8, wherein said correction circuit means is further responsive to a sign bit of the digital input data, and causes said bias voltage at said one terminal end of said R-2R resistor ladder network to vary in accordance with said control bits only when said sign bit is in a predetermined state.

## Revendications

1. Convertisseur numérique-vers-analogique pour convertir une donnée d'entrée numérique en un signal de sortie analogique comprenant :
   (a) un moyen détecteur (13) sensible à la donnée d'entrée numérique pour détecter l'amplitude de celle-ci, ledit moyen détecteur sortant un signal de détection représentatif de l'amplitude de ladite donnée d'entrée numérique ;
   (b) un moyen de conversion numérique-vers-analogique (22) d'un nombre prédéterminé de bits sensible audit signal de détection pour convertir une partie mantisse de ladite donnée d'entrée numérique en un signal analogique intermédiaire ;
   (c) un moyen de conversion d'exposant (50) sensible audit signal de détection, ledit moyen de conversion d'exposant sortant ledit signal analogique converti comme signal de sortie analogique ;
   caractérisé par :
   (d) un moyen de commande (40), incorporé dans ledit moyen de conversion numérique-vers-analogique sensible audit signal de détection pour changer le nombre de bits mis en oeuvre dudit moyen de conversion numérique-vers-analogique (22), ledit moyen de commande (40) réduisant le nombre de bits mis en oeuvre dudit moyen de conversion numérique-vers-analogique (22) en fonction de la diminution de l'amplitude de ladite donnée d'entrée numérique.

2. Convertisseur numérique-vers-analogique selon la revendication 1, dans lequel la donnée d'entrée numérique est sous la forme du complément à deux de l'amplitude de celle-ci, ledit moyen détecteur détectant le nombre de bits à "0" en tête de la donnée d'entrée numérique lorsque la donnée d'entrée numérique est positive et détectant le nombre de bits à "1" de la donnée d'entrée numérique lorsque la donnée d'entrée numérique est négative, ledit moyen détecteur sortant ledit nombre détecté en tant que ledit signal de détection.

3. Convertisseur numérique-vers-analogique selon la revendication 2, dans lequel ledit moyen de conversion numérique-vers-analogique comprend :
   un moyen de décalage numérique sensible audit signal de détection issu dudit moyen détecteur pour décaler la donnée d'entrée numérique dans le sens du bit le plus significatif de celle-ci d'un nombre de bits égal audit nombre détecté pour former ladite partie mantisse ; et
   un circuit de conversion numérique-vers-analogique du nombre prédéterminé de bits pour convertir ladite partie mantisse en une forme analogique pour produire ledit signal analogique intermédiaire.

4. Convertisseur numérique-vers-analogique selon la revendication 3, dans lequel ledit circuit de conversion numérique-vers-analogique comprend un réseau en échelle de résistances R-2R du nombre prédéterminé d'étages, les résistances 2R dudit réseau en échelle étant alimentées avec ladite partie mantisse de la donnée d'entrée numérique, une extrémité terminale dudit réseau en échelle du côté de l'étage du bit le moins significatif étant alimentée avec une tension de polarisation pour déterminer le centre de l'étendue dudit signal analogique intermédiaire, ledit signal analogique intermédiaire étant sorti de l'autre extrémité terminale dudit réseau en échelle.

5. Convertisseur numérique-vers-analogique selon la revendication 4, dans lequel ledit moyen de commande comprend un circuit de commande qui fait en sorte que les résistances 2R des étages des bits les moins significatifs dudit réseau en échelle soient alimentées avec ladite tension de polarisation pour empêcher par ce moyen lesdits étages des bits les moins significatifs de fonctionner, le nombre desdits étages des bits les moins significatifs étant déterminé en fonction dudit signal de détection.

6. Convertisseur numérique-vers-analogique selon la revendication 1, dans lequel ledit moyen de conversion d'exposant comprend :
   un moyen de circuit sensible audit signal analogique intermédiaire pour produire un nombre prédéterminé de signaux analogiques dont les tensions sont des agrandissements par $2^{-n}$ (n = 0, 1, 2, ...) dudit signal analogique intermédiaire ; et
   un moyen de circuit de commutation connecté audit moyen de circuit pour sortir de manière sélective l'un desdits nombres prédéterminés de signaux analogiques comme signal de sortie analogique en fonction dudit signal de détection.

7. Convertisseur numérique-vers-analogique selon la revendication 6, dans lequel ledit moyen de circuit comprend un réseau en échelle de résistances R-2R connecté à l'une des extrémités de celui-ci audit moyen de conversion numérique-vers-analogique.

8. Convertisseur numérique-vers-analogique selon la revendication 4 comprenant de plus un moyen de borne pour recevoir un nombre prédéterminé de bits de commande et un moyen de circuit de correction connecté à ladite une extrémité terminale dudit réseau en échelle de résistances R-2R, ledit moyen de circuit de correction faisant en sorte que ladite tension de polarisation au droit de ladite une extrémité terminale dudit réseau en échelle de résistances R-2R varie en fonction desdits bits de commande.

9. Convertisseur numérique-vers-analogique selon la revendication 8, dans lequel ledit moyen de circuit de correction est en outre sensible à un bit de signe de ladite donnée d'entrée numérique, et fait en sorte que ladite tension de polarisation au droit de ladite une extrémité terminale dudit réseau en échelle de résistances R-2R varie en fonction desdits bits de commande seulement lorsque ledit bit de signe est dans un état prédéterminé.

**Patentansprüche**

1. Digital/Analog-Wandler zur Umwandlung von digitalen Eingabedaten in ein analoges Ausgangssignal, welcher Digital/Analog-Wandler folgendes aufweist:
   (a) Detektormittel (13), die auf die digitalen Eingabedaten ansprechen, um deren Größe festzustellen, welche Detektormittel ein Detektionssignal ausgeben, das repräsentativ für die Größe der digitalen Eingabedaten ist;
   (b) Digital/Analog-Wandlermittel (22) mit einer vorgegebenen Anzahl von Bits, die auf das Detektionssignal ansprechen, um einen Mantissenteil der digitalen Eingabedaten in ein Zwischenanalogsignal zu wandeln;
   (c) Exponent-Wandlermittel (50), die auf das Detektionssignal ansprechen, welche Exponent-Wandlermittel das gewandelte Analogsignal als das analoge Ausgangssignal ausgeben;

   gekennzeichnet durch:
   (d) Steuermittel (40), die Teil der Digital/Analog-Wandlermittel sind und auf das Detektionssignal ansprechen, um die Anzahl der operativen Bits der Digital/Analog-Wandlermittel (22) zu ändern, welche Steuermittel (40) die Zahl der operativen Bits der Digital/Analog-Wandlermittel (22) mit abnehmender Größe der digitalen Eingabedaten verringern.

2. Digital/Analog-Wandler nach Anspruch 1, bei dem die digitalen Eingabedaten die Form eines Zweierkompliments ihrer Größe aufweisen, und die Detektormittel die Anzahl der führenden "0"-Bits der digitalen Eingabedaten detektieren, wenn die digitalen Eingabedaten positiv sind, und die Anzahl der führenden "1"-Bits detektieren, wenn die digitalen Eingabedaten negativ sind, welche Detektormittel die detektierte Zahl als das Detektionssignal ausgeben.

3. Digital/Analog-Wandler nach Anspruch 2, bei dem die Digital/Analog-Wandlermittel folgendes aufweisen:
   Digitalschiebemittel, die auf das von den Detektormitteln kommende Detektionssignal ansprechen, um die digitalen Eingabedaten in Richtung auf ihr höchstwertiges Bit um eine solche Anzahl von Bits zu verschieben, die gleich der detektierten Zahl ist, um den Mantissenteil zu bilden; und
   eine Digital/Analog-Wandlerschaltung mit der vorgegebenen Anzahl von Bits, um den Mantissenteil in eine Analogform zu wandeln und das Zwischenanalogsignal zu erzeugen.

4. Digital/Analog-Wandler nach Anspruch 3, bei dem die Digital/Analog-Wandlerschaltung eine R-2R-Widerstandsnetzwerkleiter mit einer vorgegebenen Anzahl von Stufen aufweist, wobei den 2R Widerständen der Netzwerkleiter der Mantissenteil der digitalen Eingabedaten zugeführt wird und ein Anschlußende der Netzwerkleiter an der Seite mit der Stufe für das niedrigwertigste Bit mit einer Vorspannung beaufschlagt wird, um die Bereichsmitte des Zwischenanalogsignals zu bestimmen, welches Zwischenanalogsignal von dem anderen Anschlußende der Netzwerkleiter ausgegeben wird.

5. Digital/Analog-Wandler nach Anspruch 4, bei dem die Steuermittel eine Steuerschaltung aufweisen, die bewirkt, daß die 2R Widerstände der Stufen für das niedrigwertigste Bit der Netzwerkleiter mit der Vorspannung beaufschlagt werden, um dadurch die Stufen für das niedrigwertigste Bit zu sperren, wobei die Anzahl der Stufen für das niedrigwertigste Bit entsprechend dem Detektionssignal bestimmt werden.

**6.** Digital/Analog-Wandler nach Anspruch 1, bei dem die Exponent-Wandlermittel folgendes aufweisen:
Schaltungsmittel, die auf das Zwischenanalogsignal ansprechen, um eine vorgegebene Anzahl von Analogsignalen zu erzeugen, deren Spannungspegel $2^{-n}$-Vergrößerungen (n = 0, 1, 2, ...) des Zwischenanalogsignals sind; und
Umschaltmittel, die an die Schaltungsmittel angeschlossen sind, um selektiv eines aus der vorgegebenen Anzahl der Analogsignale entsprechend dem Detektionssignal als das analoge Ausgangssignal auszugeben.

**7.** Digital/Analog-Wandler nach Anspruch 6, bei dem die Schaltungsmittel eine R-2R-Widerstandsnetzwerkleiter aufweisen, die mit einem ihrer Enden an die Digital/Analog-Wandlermittel angeschlossen ist.

**8.** Digital/Analog-Wandler nach Anspruch 4, der des weiteren Anschlußmittel aufweist, um eine vorgegebene Anzahl von Steuerbits zu empfangen, und der des weiteren ein Korrekturschaltmittel aufweist, das mit dem einen Anschlußende der R-2R-Widerstandsnetzwerkleiter verbunden ist, welche Korrekturschaltmittel bewirken, daß die Vorspannung an dem einen Anschlußende der R-2R-Widerstandsnetzwerkleiter sich entsprechend den Steuerbits ändert.

**9.** Digital/Analog-Wandler nach Anspruch 8, bei dem die Korrekturschaltmittel des weiteren auf ein Vorzeichenbit der digitalen Eingabedaten ansprechen und bewirken, daß die Vorspannung an dem einen Anschlußende der R-2R-Widerstandsnetzwerkleiter sich entsprechend den Steuerbits ändert, jedoch nur dann, wenn das Vorzeichenbit einen vorgegebenen Wert hat.

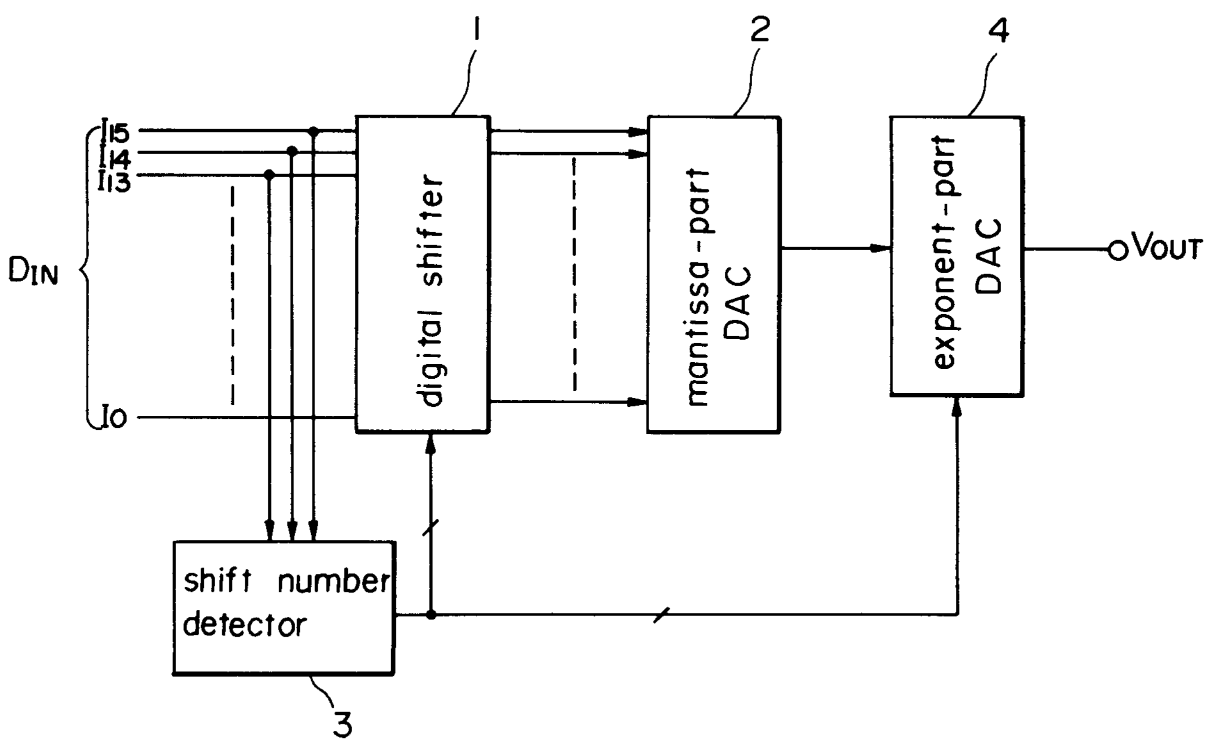
I15
I14
I13
DIN
I0
1
digital shifter
2
mantissa-part DAC
4
exponent-part DAC
VOUT
shift number detector
3

FIG.1

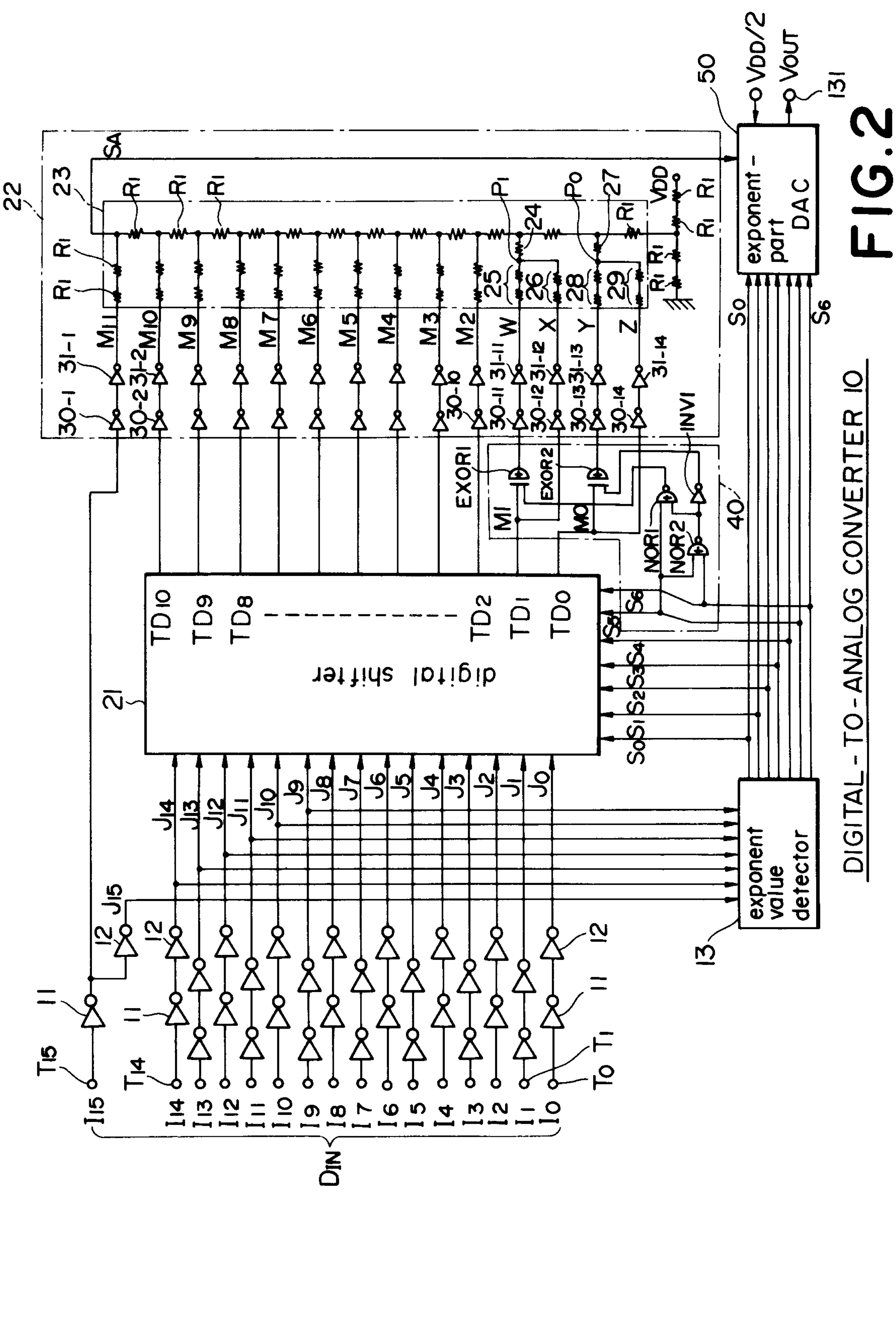


FIG.2

DIGITAL-TO-ANALOG CONVERTER 10

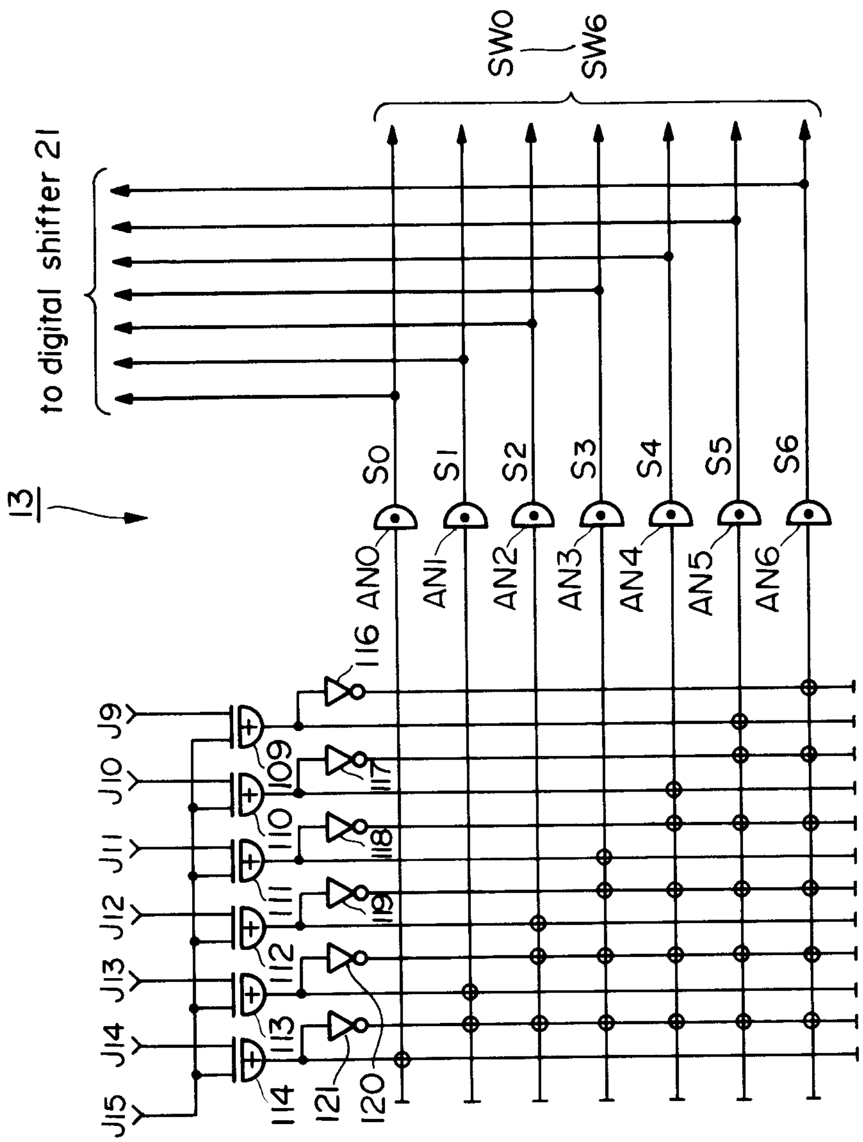


EXPONENT VALVE DETECTOR 13

FIG. 3

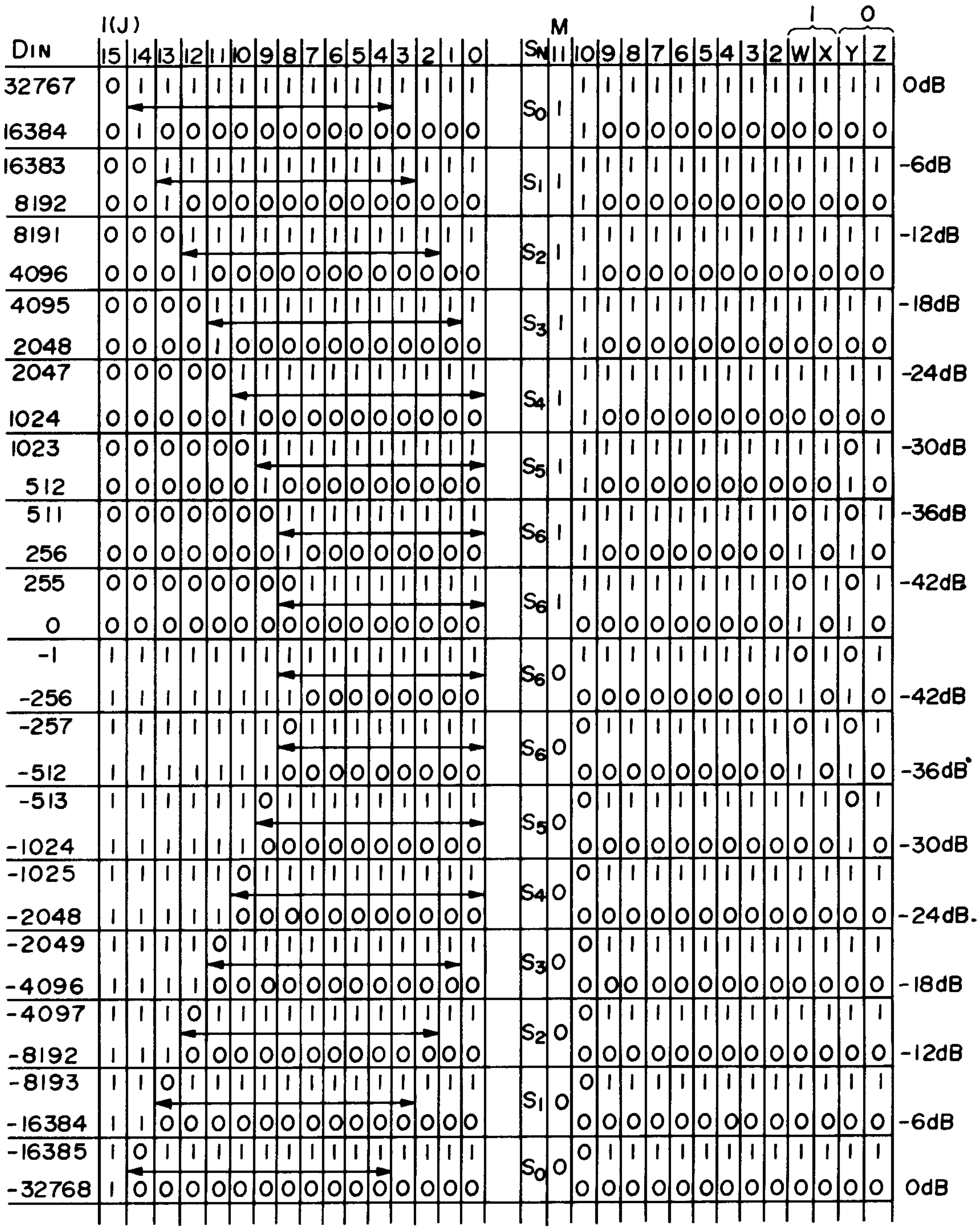

I(J)
M
I
O
DIN
15 14 13 12 11 10 9 8 7 6 5 4 3 2 1 0
SN 11 10 9 8 7 6 5 4 3 2 W X Y Z
32767
16384
16383
8192
8191
4096
4095
2048
2047
1024
1023
512
511
256
255
0
-1
-256
-257
-512
-513
-1024
-1025
-2048
-2049
-4096
-4097
-8192
-8193
-16384
-16385
-32768
S0 S1 S2 S3 S4 S5 S6 S6 S6 S6 S5 S4 S3 S2 S1 S0
0dB
-6dB
-12dB
-18dB
-24dB
-30dB
-36dB
-42dB
-42dB
-36dB
-30dB
-24dB.
-18dB
-12dB
-6dB
0dB


FIG.4

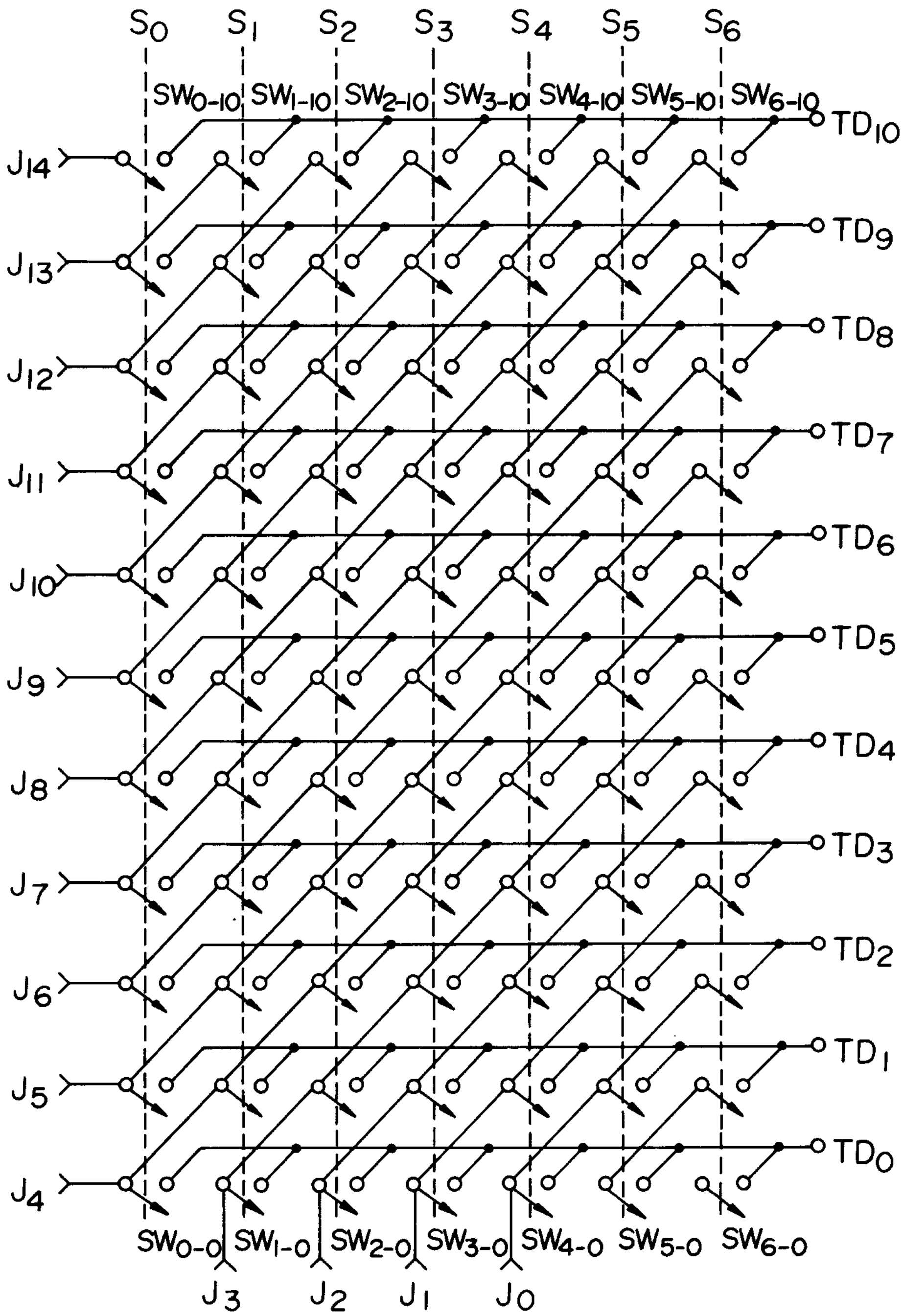


DIGITAL SHIFTER 21

FIG.5

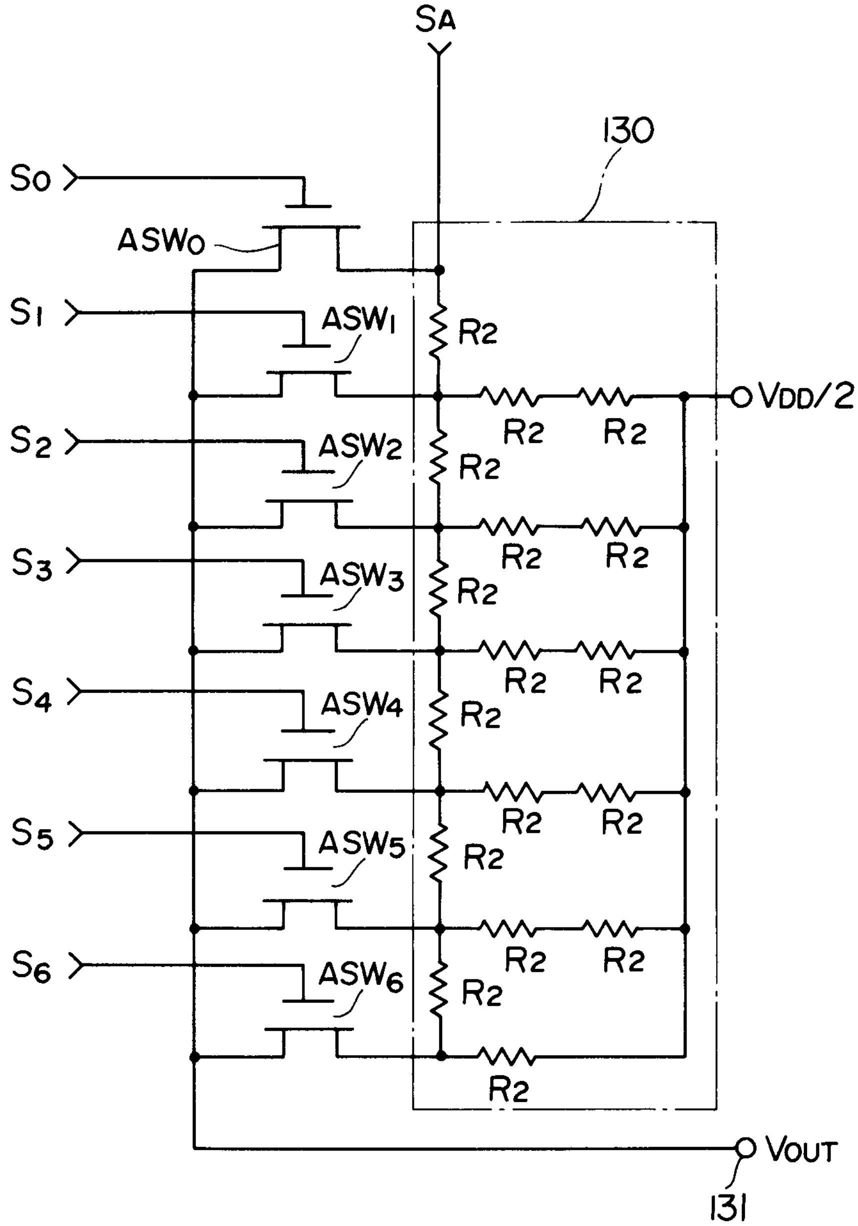


EXPONENT-PART DAC 50

FIG.6

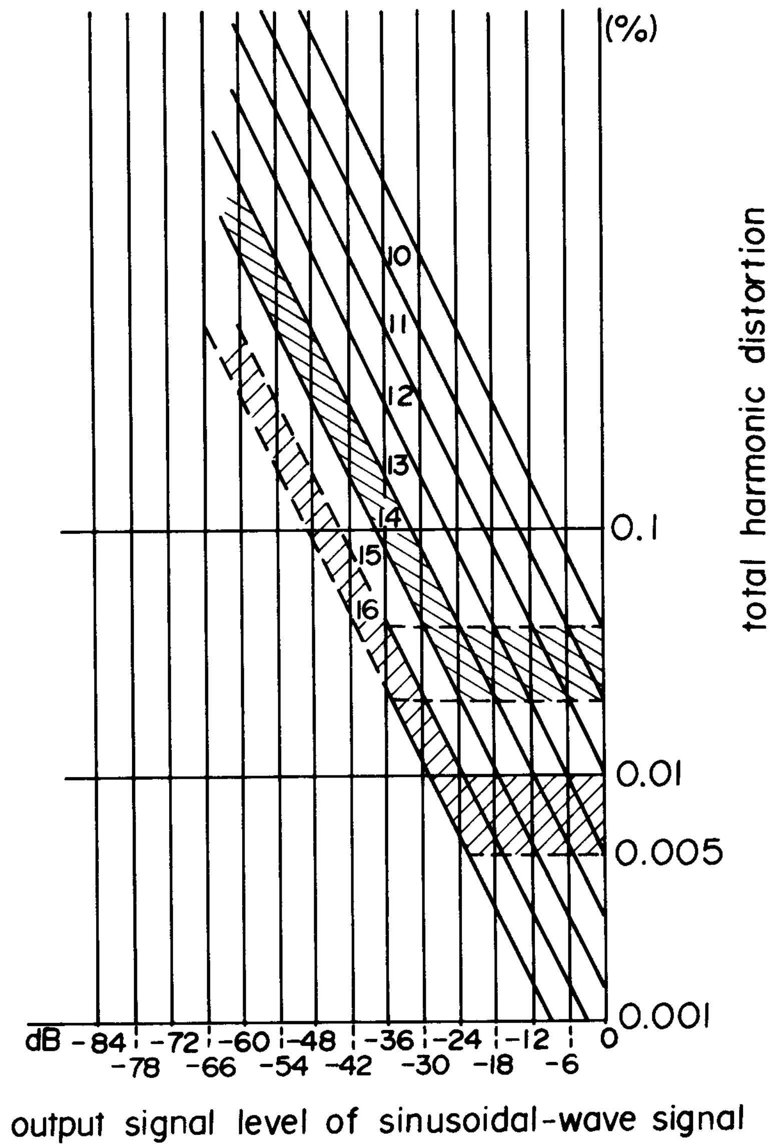
(%)
10
11
12
13
14
15
16
0.1
0.01
0.005
0.001
total harmonic distortion
dB -84 -72 -60 -48 -36 -24 -12 0
-78 -66 -54 -42 -30 -18 -6
output signal level of sinusoidal-wave signal

FIG. 7

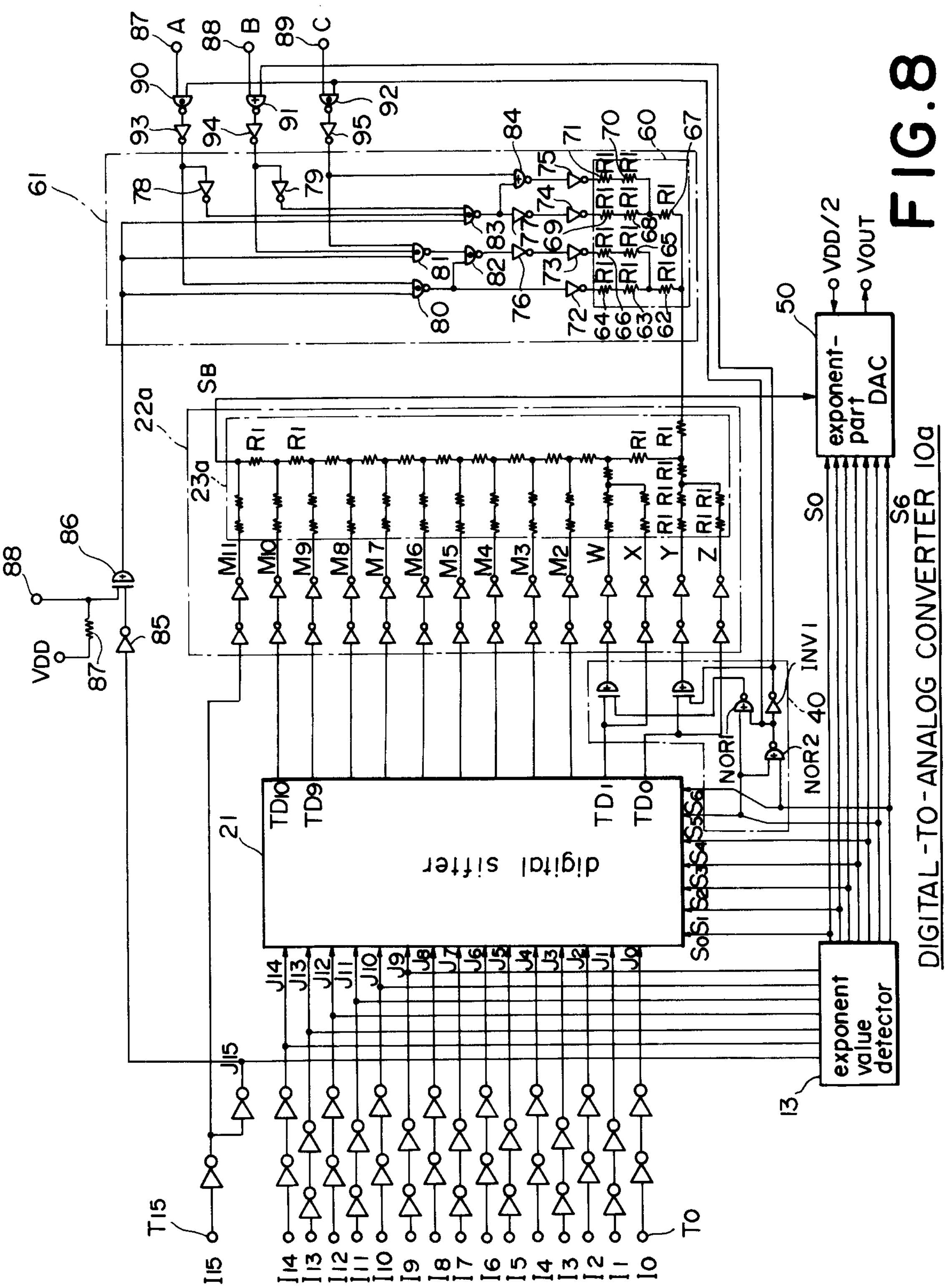


FIG.8

DIGITAL-TO-ANALOG CONVERTER 10a